# EUROPEAN PATENT SPECIFICATION

(11) **EP 1 231 827 B1**
(45) Date of publication and mention of the grant of the patent: **10.11.2004**
(21) Application number: 01610009.1
(22) Date of filing: 09.02.2001
(51) Int. Cl.: H05K 9/00

(54) **Gasket with bend projections and method of manufacturing the same**
Kontaktstreifen mit gebogenen Projektionen und Herstellungsverfahren
Bande de contact avec des projections repliées et méthode de fabrication

(43) Date of publication of application: 14.08.2002
(73) Proprietor: SAVCOR DENMARK A/S, 2750 Ballerup (DK)
(72) Inventor: Traberg, Lars, LK Engineering A/S, 2100 Copenhagen (DK)
(74) Representative: Sundien, Thomas

(56) References cited:
- EP-A- 0 902 615
- EP-A- 0 952 765
- US-A- 5 679 923

## Description

### FIELD OF THE INVENTION

The present invention relates in its broadest concept to a conducting contact means for providing contact between two components as well as a method of manufacturing the same. More specifically the present invention relates to a finger-like member projecting from a relatively thin sheet-member, and most specifically the present invention relates to a conductive EMC gasket comprising a plurality of finger-like projecting members according to the invention.

### BACKGROUND OF THE INVENTION

Electromagnetic interference is a common and well-known problem associated with electronic equipment. Normal circuit operation creates electromagnetic waves which induce undesirable signals and interfere with the normal operation of other electrical components. These undesirable signals, termed electromagnetic or RF (radio frequency) interference, can be minimized by shielding portions of the circuit within a conductive shield at a low or ground potential. This grounded electromagnetic shield dissipates electrostatic build-up and absorbs the electromagnetic field thereby shielding the circuit from electromagnetic interference.

A typical field in which electromagnetic interference concerns are present is in the design of mobile phones. Depending on the actual design, it may be necessary to either shield specific components inside the apparatus itself against electromagnetic interference, in- or outgoing, or to shield the apparatus as such with a housing functioning as an overall shield.

In the past, it has been common practice to solder an electromagnetic shield to a ground trace formed on a printed circuit board of a radiotelephone. This approach obviously yields excellent conductive contact between the shield and the ground trace of the printed circuit board. However, soldering the electromagnetic shield to the printed circuit board makes inspection and repair of the printed circuit board practically impossible. It is highly desirable for the shield and printed circuit board to be of a design that readily accommodates inspection and repair.

Conductive gaskets can also be used as a conductive interface between an electromagnetic shield, either between a housing and the printed circuit or between two housing components, e.g. an upper and a lower housing for a mobile telephone.

Spring clips and fingers have been utilized in mobile phones fcr the purpose of maintaining conductive contact between an electromagnetic shield and a ground trace formed on a printed circuit board. See, for example, the disclosure of U.S. Pat. No. 5,053,924 in which contact-providing elastic clip members are mounted on a housing. Indeed, the mounted clip members add to the complexity, size and costs for the overall shielding device.

A more recent approach is disclosed in U.S. Pat. No. 5,748,455 which discloses an electromagnetic shield including a face and a sidewall extending around the face, and with a series of spaced apart, integrally formed spring contacts extending from the sidewall of the shield and making electrical contact with the ground trace of the printed circuit board.

As mentioned above, the electronics of, for example, a mobile phone can also be shielded by one or more conductive gaskets. For example when two or more housing parts are used to enclose the circuitry, a gasket is placed between the conductive housing parts in order to establish electrical contact between the parts which can be manufactured from either metal or metalized plastics. Such a gasket can also be used between an internal shield and a circuit board. In order to maintain conductive contact between the housing parts, the principle of spring contacts has also been utilized for the gaskets. For example, U.S. Pat. No. 5,039,825 discloses an arrangement in which a corrugated strip serves as a gasket, and where the force exerted by the corrugated strip provides electrical continuity between the conductive surfaces to be connected by the gasket.

A more recent gasket is disclosed in the brochure "EMC metal gaskets" published by LK Engineering as, DK-2100 Copenhagen, Denmark. The disclosed metal gasket consists of a frame adapted to follow the contour to be shielded, i.e. the contacting area between two components. To ensure contact the frame comprises a number of small contact springs, typically 1-1.5 mm in length integrated into the frame and bend out of the general plane of the gasket. As above, screening takes place by the springs creating electrical contact between, for example, the shield and the circuit board. To ensure low force of compression, the thickness of the springs is reduced in comparison to the frame portion of the gasket.

In order to ensure good contact between the two compo nents, the contact springs may be bend in opposite directions, see US 5679923. It is evident that the more springs are provided, the better a contact is achieved between the two components, however, a larger number of spring contacts will normally result in shorter individual springs which are then capable of spanning a reduced gap only between the two components to be connected, as well as a higher compression force would be needed during assembly. Further, a very large number of contact springs bend in opposite directions also makes manufacturing as well as handling more difficult. According to the technique of US5679923 the contact points will comprise a rounded knee between the mutually bending spring parts. Such a rounded contact point will reduce the ability to go though the oxide layer of a metal surface.

It is therefore a first object of the present invention to provide a means for achieving improved contact between two components, specifically, it is an object to provide a configuration in which a metal gasket comprising finger-like projections ensures effective contact between the components to be electrically connected.

In general, the above-described types of gaskets may be very thin, typically 0.15 mm and comprising a large number of very small springs. Further, the gasket portions carrying the springs may have dimensions (for example the width) which is in the same range as the springs, correspondingly, creating the small contact springs in an automated process by permanently deforming (bending) portions of the gasket (or housing) has been both time-consuming and costly, the latter due to the high costs of the tools necessary, as it has been necessary to clamp the portion of the gasket next to the portion (e.g. finger-like projection) to be bend, this in order to control the bending process. If the "spring-carrying" gasket portion was not clamped it would just flex elastically together with the projection resulting in either no permanent deformation or an irregular and uncontrolled bending. Adding further to the complexity is the desire, for example for gaskets of the rim-type, to have the spring contacts bend in alternating directions.

It is therefore a further object of the present invention to provide a method in which projections according to the invention and arranged on a sheet-like base member can be bend cost-effectively; specifically, it is an object to provide an efficient method in which finger-like projections on a metal gasket can be bend in order to provide contact springs at least partially protruding from the general plane of the gasket.

As appears from the above, preferred embodiments of the invention are in the form of relatively thin, sheet-like members, e.g. metal gaskets, which means, unless otherwise stated, that the term thickness refers to the thickness of such a sheet-like member, whereas the dimensions of the extensions are referred to as length and width.

### SUMMARY OF THE INVENTION

The invention is based on the general concept that each of the finger-like projections comprises an outer portion having a free end and being bend out of the general plane of a base member and an inner portion arranged between the base member, e.g. the gasket frame, the inner portion being arranged either in the general plane of the base member or bend in the opposite direction with respect to the outer portion. In this way the inner portion provides a hinge between the base member and the outer portion of the finger-like projection.

According to the invention a first portion of the inner portion has a reduced thickness and a second portion of the inner portion comprises a protruding contact means, the first portion being arranged between the base member and the second portion.

The inner portion will accordingly comprise a raised portion protruding in a direction opposite the bend outer portion of the extension, this ensuring that a well-defined contact is provided between the second object and the inner portion of the extension.

The thickness may be reduced by chemical milling whereby an edge can be provided between the raised portion and said first portion. Such an edge will result in a very effective electrical contact compared to a bended knee.

In a further preferred embodiment, the outer portion is bend along a line non-perpendicular to a general longitudinal orientation of the base member, this providing a twisting of the projection, and thus an improved contact, when the conducting contact means is arranged between two components.

The present invention, according to a further aspect, is based on the realization that reducing the relative thickness of the projections to be bend as compared with the main element makes it possible to bend the projections without the need for clamping the main element.

According to the further aspect the invention, a method is provided in which a portion of a projecting element on a member (also called a base) is bend without the use of initial clamping means, and where a major part of the at least one projecting element has a reduced thickness relative to the member. Preferably the member has a sheet-like configuration with finger-like projections, and more preferably the sheet-like member comprises a plurality of extensions which are bend in opposite directions, i.e. at least one projection being bend in a first direction and at least one projection being bend in the opposite direction. The definition "without the use of clamping means" defines that the projecting element is bend between cooperating tool portions, the portion of the (sheet-like) member carrying the projecting element having at least one free surface during at least the initial bending procedure. In a preferred embodiment the sheet-like member with its projections forms an EMC metal gasket for providing effective mechanical screening against electromagnetic radiation in mobile phones, portable computers, and other forms of small and/or portable communication equipment.

Other objects and advantages of the present invention will become apparent and obvious from a study of the following description and the accompanying drawings, which are merely illustrative of such invention.

### BRIEF DESCRIPTION OF THE DRAWINGS

Figs 1-3 show different arrangements for bending the projections to obtain a reliable electrical contact,
Fig. 4A shows a first embodiment of the invention;
Figs. 4B and 4C show cross-sectional views of the first embodiment along the line A-A in Fig. 4A;
Figs. 5A and 5B shows further embodiments of the invention;
Figs. 6A-6I show the different stages in manufacturing a gasket blank using chemical milling, the blank being shown in sectional views;
Figs. 7A and 7B show the bending procedure according to the present invention;
Fig. 8 shows an embodiment of a tool to be used with the present invention; and
Fig. 9 shows (in partial) an actual embodiment of an EMC metal gasket which advantageously could incorporate a spring contact according to the present invention.

### DETAILED DESCRIPTION OF THE INVENTION

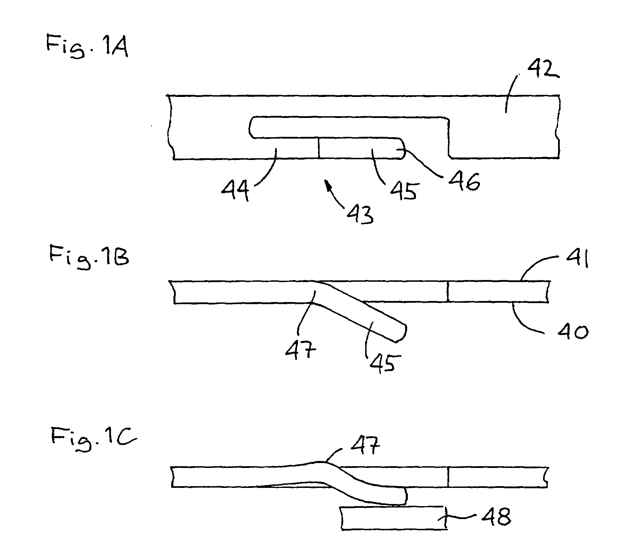

With reference to Figs. 1-3 a known embodiment of a finger-like spring contact will be described.

Fig. 1A-1C show a rim portion of an EMC metal gasket seen in a direction perpendicular to the general plane of the gasket. The gasket has first and second surfaces 40, 41 and comprises a base member portion 42 and a spring contact in the form of a finger-like extension 43 with an inner portion 44 and an outer portion 45 having a free end 46. As can be seen from the cross-sectional view in Fig. 1B the inner portion extends in the general plane of the gasket whereas the outer portion is bend out of the general plane, the extension thereby having a "knee" 47 between the two portions. When the first surface of the gasket is placed against a first component 48, thereby providing a well defined contact between the gasket and the first component, the outer portion flexes towards the general plane of the gasket, however, as the outer portion is attached to the inner portion, the inner portion and thus the "knee" is forced to flex out of the general plane in the opposite direction, this as illustrated in Fig. 1C. When a second component (not shown) is placed against the second surface the knee will serve as a further contact point providing a well defined contact between the gasket and the second component.

In the above-described known embodiment the finger-like extension has the same thickness as the base member, i.e. the gasket has a constant over-all thickness. However, as will be apparent from the following description, the finger-like extension may advantageously be of reduced thickness as compared to the rim or base member, this allowing for ease of bending.

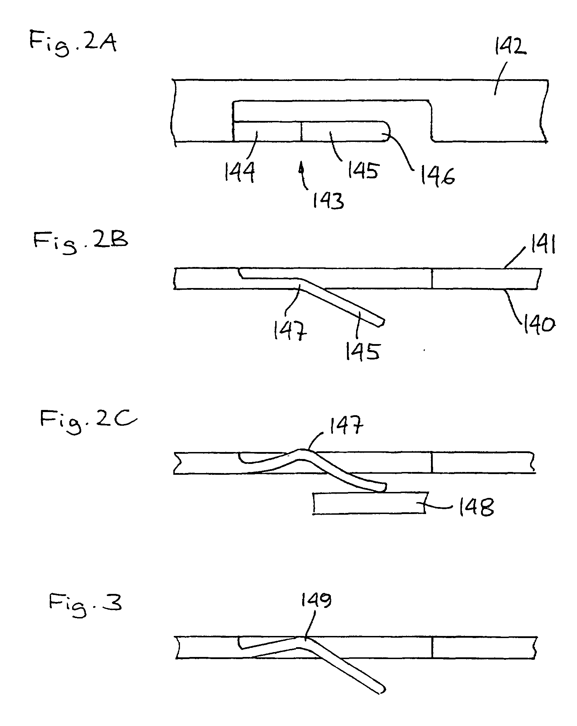

The gasket has first and second surfaces 140, 141 and comprises a base member portion 142 and a spring contact in the form of a finger-like extension 143 of reduced thickness as compared to the rim or base member and with an inner portion 144 and an outer portion 145 having a free end 146. As can be seen from the cross-sectional view in Fig. 2B the inner portion extends in the general plane of the gasket corresponding to the first surface of the gasket whereas the outer portion is bend out of the general plane, the extension thereby having a "knee" 147 between the two portions. When the first surface of the gasket is placed against a first component 148, thereby providing a well defined contact between the gasket and the first component, the outer portion flexes towards the general plane of the gasket, however, as the outer portion is attached to the inner portion, the inner portion and thus the "knee" is forced to flex out of the general plane in the opposite direction, this as illustrated in Fig. 2C. When a second component (not shown) is placed against the second surface the knee will serve as a further contact point providing a well defined contact between the gasket and the second component.

As appears from Figs. 2A-2C the contact point or "knee" 147 is arranged at a distance from the second surface of the gasket such that the contact point has to travel a distance in order to provide contact with a component arranged in contact with or in the vicinity of the second "general" surface of the gasket. In the illustrated embodiment the inner portion is relatively long thus allowing for easy flexing of the knee, however, this necessitates a given, relatively large movement of the outer free portion of the extension. Further, given a total length of the extension, the relatively long inner portion will result in a relatively short outer portion with a reduced potential of travel.

In order to provide secure contact between the knee and the second component the inner portion may be bend in the opposite direction of the outer portion as can be seen in Fig. 3. According to circumstances, the inner portion may be bend in such a way that the knee in an unloaded condition is arranged below, on or above the general plane of the second surface of the gasket. In the illustrated embodiment the knee is arranged substantially in the plane of the second surface such that only a small flexing of the outer free portion will result in the knee being located above this plane.

However, this embodiment has some drawbacks. If it is desirable to have a relatively long outer portion for a given total length of the extension, this will result in a short and relatively stiff inner portion which will only bend to a small degree, this being a problem especially in an embodiment as shown in Fig. 2B. Further, a double bend extension, or spring contact, is complicated and thus expensive to manufacture.

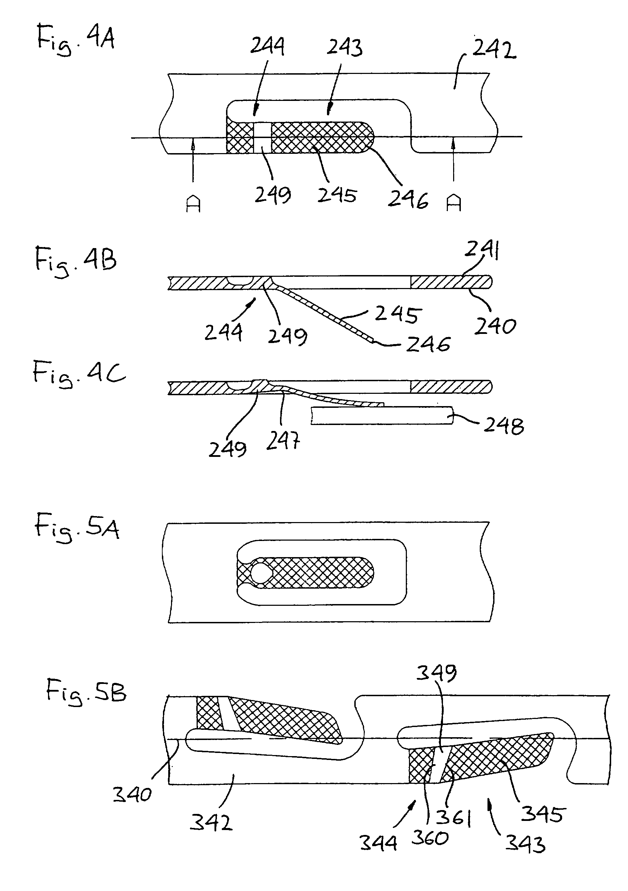

According to the invention these drawbacks are avoided as shown in Figs. 4A-4C. The gasket shown in Figs. 4A-4C has first and second surfaces 240, 241 and comprises a base member portion 242 and a spring contact in the form of a finger-like extension 243 generally of reduced thickness as compared to the rim or base member and with an inner portion 244 and an outer portion 245 having a free end 246. As can be seen from the cross-sectional view in Fig. 4B the inner portion extends in the general plane of the gasket corresponding to the first surface of the gasket whereas the outer portion is bend out of the general plane, the extension thereby having a "knee" 247 between the two portions, however, in contrast to the embodiments shown in Figs. 1-3, an additional contact means 249 is provided on the inner portion corresponding to the "knee area". Preferably the contact means is a protrusion on the inner portion formed integrally therewith and providing the inner portion with an area having the same thickness as the base member 242 to which it is attached, thus providing a contact point in the plane of the second surface of the gasket. Preferably the reduced thickness portions as well as the contact means are provided using an etching technology as will be described below.

When the first surface of the gasket is placed against a first component 248, thereby providing a well defined contact between the gasket and the first component, the outer portion flexes towards the general plane of the gasket, thus forcing the contact means 249 to flex out of the general plane in the opposite direction, this as illustrated in Fig. 4C. When a second component (not shown) is placed against the second surface the contact means 249 will serve as a further contact point providing a well defined contact between the gasket and the second component. In contrast to the previous embodiments, this arrangement ensures that the contact member can be formed with a relatively long outer portion and that only a minimal flexing thereof will result in the additional contact means 249 being forced towards the second componer.t (not shown).

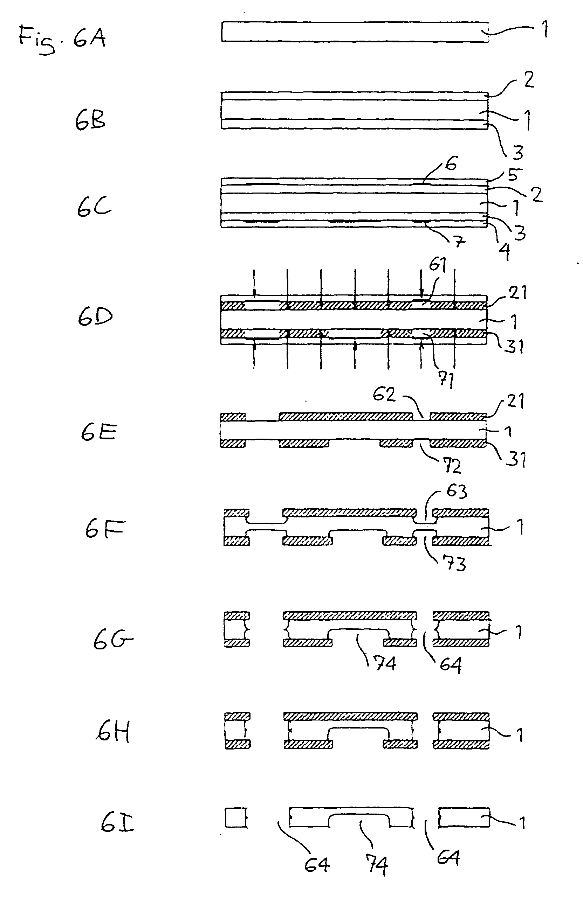

The additional contact means may have any desired configuration, for example as illustrated in Figs. 5A and 58, as well as the inner and outer portion may be formed with any desired form.

More specifically, Fig. 5A shows the additional contact means 250 having a substantially circular form, however, in order to ensure proper electrical contact between the additional contact means and the component against which the gasket is placed, the contact means is formed with a pointed member 251 facing in the direction of the free end 246 of the extension. As described above, it is often desirable to provide an as long as possible outer portion of the extension, this leaving only a short inner portion which may then be relative stiff. Further, when a gasket comprising a contact means according to a preferred embodiment of the present invention is manufactured using etching technology (as will be described below) it is often difficult to substantially reduce the thickness between two raised areas, as would be the case for the reduced thickness portion of the inner portion 244 of the extension between the base member 242 and the contact means 250. To thus provide a softer hinge between the base member and the outer portion 245, the inner hinge portion 252 may have a reduced width, for example by symmetrical cut out portions on either site as shown in Fig. 8A.

In the Figs. 1-4 embodiments the finger-like extension is arranged corresponding to a free edge of the base member 42, 142, 242, however, the finger-like extension may also be arranged in a "closed" opening in the base member as illustrated in Fig. 5A, the extension thus being entirely surrounded by the base member.

In the Figs. 1-5 embodiments the finger-like extension has a longitudinal configuration with a general orientation along the length thereof, and is bend along a line substantially perpendicular to the general longitudinal orientation of the extension, however, the finger-like extension may also be arranged to bend along an "inclined" non-perpendicular line as will be described with reference to Fig. 5B.

Fig. 5B shows a rim like portion of a base member 342 with a general longitudinal orientation along a central line 340 and having finger-like extensions 343 arranged corresponding to either side thereof. Each extension comprises an outer portion 345 and an inner portion 344 both having a generally reduced thickness as compared to the base member, the inner portion comprising a raised portion 349 providing a contact means, as also described with reference to Figs. 4A-4C. The contact means 349 has a bridge-like configuration with an inner edge 360 and an outer edge 361 towards the inner respectively the outer portions of the extension; as can be seen both the inner and outer edge is inclined. The outer portion is bend corresponding to the outer edge in a direction downwardly with respect to the paper plane and the general plane of the base member, this resulting in the outer portion being bend inwardly as well in the direction of the central line 340. When the first (here: the lower) surface of the gasket is placed against a first component (not shown), thereby providing contact between the outer portion 345 of the extension and the first component, the outer portion flexes towards the general plane of the gasket, thus forcing the contact means 349 to flex out of the general plane in the opposite direction, however, due to the inclined orientation of the bending line, the contact means 349 will be twisted out of the general plane of the base member, whereby a very well defined contact will be established between an edge portion of the raised contact means and a second component (not shown) placed against the upper surface of the base member. To prevent the rim like base member from "tilting", preferably the inclined bend extensions are arranged in an alternating fashion along the sides of the rim. In the shown embodiment the extension is bend along a line parallel to the outer edge 361 of the raised contact means.

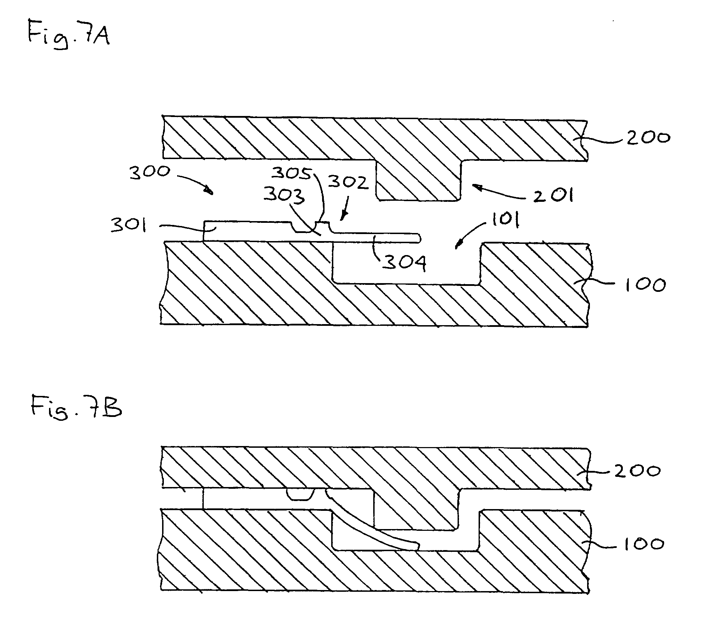

With reference to the Figs. 6A-6I a preferred method for manufacturing a gasket to be bend in accordance with the present invention will be described, i.e. a method for manufacturing a gasket comprising a number of finger-like extensions having a reduced thickness, in the following called a blank, i.e. when in the state before bending takes place. The described steps of manufacturing such a blank is not part of the present invention but is only provided for more fully understanding the manufacturing aspect of the present invention.

The illustrated method is normally known as chemical milling and is based on the principle that portions of a metal member, often a sheet-like member, are removed by etching from the surface of the member. Apertured masks for colour televisions are a well-known product manufactured by this technique.

In large-scale production an endless metal sheet (also called web) for a large number of items is passed through a number of stations in which the different steps are performed. Fig. 6A shows in a partial sectional view a metal web 1, which for an EMC gasket may be 0.15 mm tempered stainless steel (1800 N/mm⁻), and which after having been cleaned subsequently is covered with a coating 2, 3 on respective sides, see Fig. 6B. Thereafter masking foils 5, 4 with the pattern 6, 7 to be etched on the respective sides of the web are placed on top of the coating layer, see Fig. 6C. The web is then exposed to, for example, UV light (see Fig. 6D) and subsequently developed such that the exposed coating forms an etchant resist coating 21, 31 with the non-exposed areas 61, 71 of the coating being removed to leave the metal web unprotected at 62, 72 corresponding to the pattern of the mask, see Fig. 6E. It is these portions of the metal web which are to be etched during the subsequent etching procedures.

Thereafter the web is passed through one or more etching stations (not shown) wherein a plurality of upper and lower etchant spray nozzles are arranged to allow the etchant spray to be dispersed over a wide area. Fig. 6F shows that the unprotected areas 63, 73 are partly etched and Figs. 6G and 6H show that openings 64 are formed whereas the portions of the web with resist coating on only one side have given rise to areas 74 with reduced thickness. Fig. 6I shows the finished web with the resist coating removed.

The manufacturing method described with respect to Figs. 6A-6I illustrates the principle of chemical milling. However, in order to manufacture a blank to be used with the present invention, the projections to be bend will be formed as portions 74 with reduced thickness surrounded (apart from the "hinge" portion) by etched-through portions 64.

In case etching is performed from only one side, either locally or generally, the non-etched portions form a continuous, non-stepped surface, which is by definition not influenced by any subsequent bending procedures.

As mentioned above, a large number of items, e.g. blanks, are formed on the web, the individual blanks being connected to each other by a number of "external" bridges. If the blank is in the form of a rim-like member the "internal" portion is also connected with a number of bridges. After etching the internal web portions are removed, for example by stamping, as well as all or some of the external bridges, this resulting in either individual blanks or "biscuits" comprising a number of blanks typically arranged on a string for better handling.

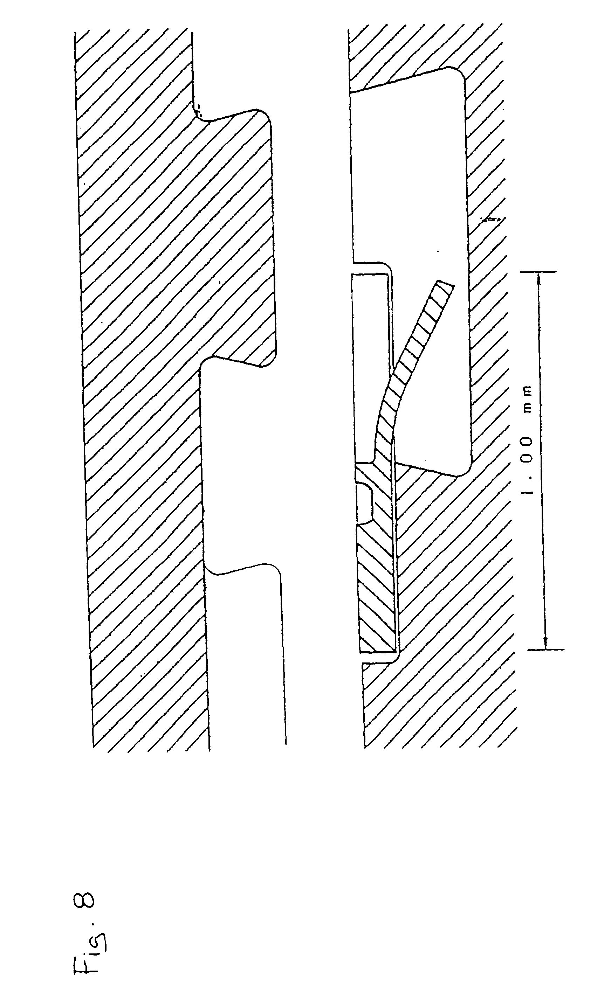

Next the bending procedures according to the present invention will be described with reference to Figs 7A and 7B. The shown bending tool comprises a first 100 and a second 200 tool portion, which in the shown embodiment represent lower and upper tool portions respectively. The two tool portions comprise corresponding bending means in the form of a recessed area 101 in the lower tool portion and a projection 201 on the upper tool portion. By the term "corresponding" is meant that the projection(s) 201 can be advanced into the recessed area(s) 101 when the two portions are properly brought into register with each other, however, apart from the recess having dimensions in the plane of the tool which are larger than the corresponding dimensions of the projection, the dimensions do not necessarily correspond to each other, e.g. the depth respectively the height can be different. Apart from the recesses and projections, the tool portions comprise a generally planar surface.

Between the two tool portions is arranged a blank 300 to be bend. The blank comprises a base portion 301 (which for an EMC gasket would be the rim-portion) from which a finger-like extension 302 projects, the extension generally having a reduced thickness as compared with the base portion, preferably between ½ (as shown) and ¼, most preferably 1/3. The extension comprises an inner portion 303 with a raised contact member 305 and an outer portion 304.

For the purpose of definition, the blank has a first lower and a second upper general surface on opposite sides thereof, these surfaces also defining the corresponding surfaces on the base portion and the extension, which in the shown embodiment means that the lower surfaces of the base member as well as the inner and outer portions of the extension are all in the plane of the lower general surface, whereas the upper surfaces of the inner and outer portions of the extension are below the upper general surface, the upper surfaces of the base member and the contact member being in the upper general plane.

In the shown embodiment the blank is placed on the lower tool portion with the first surface of the base member and the inner portion 303 of the extension arranged on the upper surface of the lower tool portion 100, whereas the first surface of the outer portion 304 of the extension protrudes freely above the recessed area 101. Indeed, although only one extension is shown, the blank normally comprises several such extensions which are arranged on a corresponding number of projections on the lower tool portion. In order to correctly align the blank on the lower tool portion, corresponding guiding means should be provided, for example upstanding guide means on the lower tool portion which catch corresponding openings in the blank. In the shown embodiment the blank has been placed with the flush surface downwardly, however, this could have been reversed just as a blank may comprise extensions which have been etched down from opposite sides.

When the blank has been properly arranged on the lower tool portion either manually or automatically, either as a single blank or as a biscuit comprising a plurality of blanks) the upper tool portion is lowered and forced down against the blank. First the lower surface of the projection 201 comes into contact with the upwardly facing second surface of the outer portion 304 of the extension (this step is not shown) resulting in the outer portion being bend in the downward direction by the projection 201, generally in a direction perpendicular to a general plane of the blank. Due to the reduced thickness of the extension 304 plastic deformation will take place between the inner and outer portions of the extension with only minimal or no "lifting" of the inner portion 303 or the base 301 from the surface of the lower tool portion. In the shown embodiment the downwards movement of the upper tool portion stops when the lower surface of the upper tool portion contacts the upwardly facing surfaces of the contact member 305 and the base portion 301, however, the downwards movement can be stopped before this happens as long as the desired plastic deformation is achieved. Indeed, without such a contact, some other kind of a stop-means has to be applied.

Finally, the upper tool part is lifted away and the finished item, or the processed blank, is removed from the bending tool, this resulting, for example, in a rim-like EMC metal gasket comprising a plurality of finger-like extensions which may be bend both up- and downwardly relative to the general plane of the gasket. The finished gasket is thereafter supplied to the customer as requested, e.g. as single units, in biscuits, on tape or in trays for SMD assembly, or mounted on shields.

Fig. 8 shows a further embodiment of a tool (drawn to scale to be used with the present invention. In contrast to the above example, the base portion is placed in a recess which then serves as a locating means for properly placing the blank in the lower tool portion.

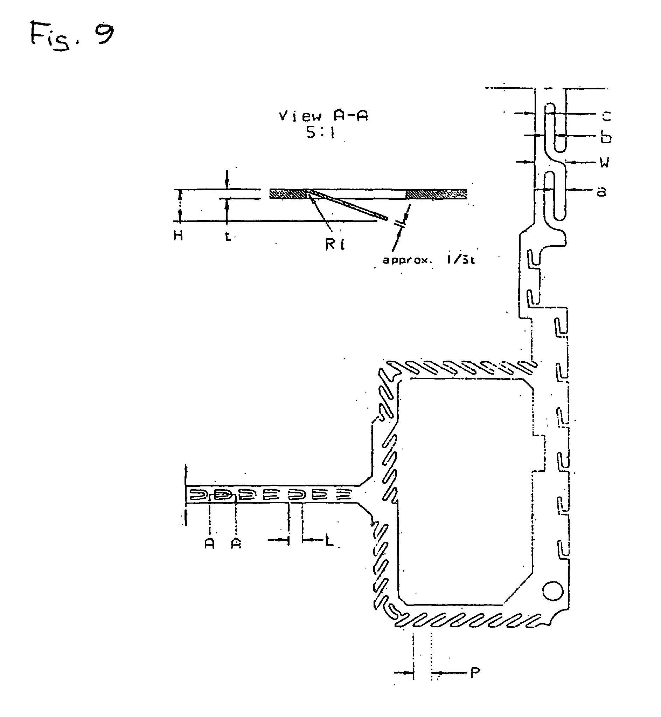

Fig. 9 shows (in partial) an actual embodiment of an EMC metal gasket which advantageously could be manufactured using the method of the present invention (the spring contact shown in cross-section is not made in accordance with the present invention). As can be seen the gasket is made up of rim-like portions which in combination form one or more closed rim-portions of which one is shown. The following values given are only illustrative for this application and can be chosen according the desired application. Material example: 0.15 mm (= t) 7C27Mo2 hardened stainless steel; tensile strength: 1800 N/mm²; modulus of elasticity: 2.1 x 10⁵ N/mm²; width of frame W = 0.80 mm, length of springs L = typically 1-1.5 mm, height of springs H = typically 0.3-1.0 mm, minimum pitch between springs P = 1.2 mm; a not less than 0.30 mm, b not less than 0.25 mm and c not less than 0.25 mm.

As appears from the above, the pressing tools to be used with the present invention are rather delicate with recesses and projections having very small dimensions, i.e. height and depth less than 1 mm. To produce such tools, conventional cutting or spark machining can be used.

However, a bending tool may also be manufactured using an etching technology principally as described above with respect to the manufacture of the blank. If a surface on the etched tool is to have more than two "levels", for example when it is desirable that a tool portion on its "general" surface has both projections and extensions, then a two-step (or more) etching process will have to be applied with the application of further resist layers onto the partly etched tool member.

While the present invention has been described in connection with the preferred embodiments shown in the various figures, it is to be understood that other similar embodiments may be used or modifications and additions may be made to the described embodiment for performing the same function of the present invention without deviating there from. For example the base portion to which the extensions are attached could be attached to a further member, e.g. the base could form an edge portion of a shield housing. The base member does not solely have tc be manufractured from a metal but could be made of any material or combination of materials which could be bend in accordance with the present invention.

Therefore, the present invention should not be limited to any single embodiment, but rather construed in accordance with the appended claims.

When in the claims a general plane of the base member is defined, this, in the case of a gasket, normally refers to the "overall" general plane of the gasket; however, a gasket or any other specific component may comprise a number of interconnected base members arranged in different planes. This consideration as to "general" also implies to embodiments in which e.g. a gasket comprises a number of rim like portions, each defining a general longitudinal orientation thereof.

## Claims

1. A conducting contact means for providing contact between two components, comprising a base member (242) defining a general plane and having at least one extension (243) projecting from the base member, the base member and the extension both having a first surface (240) and an opposite second surface (241), wherein the extension (243) comprises an inner portion (244) and an outer portion (245), the inner portion (244) being connected to the base member, the outer portion (245) being bend relative to the inner portion and out of the general plane of the base member, wherein a first portion of the inner portion (244) has a reduced thickness and a second portion of the inner portion comprises a protruding contact means (249), the first portion being arranged between the base member and the second portion.

2. A conducting contact means as defined in claim 1, wherein the reduced thickness is performed by means of a chemical milling process.

3. A conducting contact means as defined in claim 2, wherein the contact means is formed integrally with the extension and has a thickness substantially corresponding to the portion of the base member to which it is attached.

4. A conducting contact means as defined in any of claims 1-3, wherein the base member comprises a rim like portion having a general longitudinal configuration defining a general longitudinal orientation, and wherein the outer portion is bend out of the general plane of the base member along a bending line which is non-perpendicular with respect to the general longitudinal orientation of the rim like portion.

5. A conducting contact means as defined in any of claims 1-4, wherein the extension has a general longitudinal configuration defining a longitudinal orientation, and wherein the outer portion is bend out of the general plane of the base member along a bending line which is non-perpendicular with respect to the longitudinal orientation of the extension.

6. A conducting contact means as defined in any of claims 1-5, wherein the inner portion is arranged either in or bend out of the general plane of the base member.

7. A conducting contact means as defined in any of claims 2-6, wherein the first surface of the extension and the first surface of the portion of the base member to which it is attached form a continuous, non-stepped surface.

8. A conducting contact means, wherein the base member comprises a rim portion having a plurality of finger-like extensions arranged thereon, at least one thereof as defined in any of claims 1-7.

9. A conducting contact means as defined in claim 8, wherein the base member is a substantially planar, thin metal member, preferably with a thickness less than 1 mm.

10. A conducting contact means as defined in claim 9, wherein the blank comprises at least one closed rim-like portion, the bend extensions forming spring contacts.

11. A method for bending at least one extension projecting from a base member, the method comprising the steps of:
- providing a blank comprising a base member (301) having at least one extension (302) projecting from the base member in a general plane of the base member, the base member and the extension both having a first surface and an opposite second surface, the extension comprising an inner portion (303) and an outer portion (304), the inner portion being connected to the base member, and the outer portion having a reduced thickness relative to the portion of the base member to which the extension is attached;
- providing a bending tool comprising a first and a second tool portion (100, 200), the tool portions comprising, when arranged in register with each other and the blank, at least one projection (201) on one of the tool portions and a corresponding recess (101) in the other tool portion into which the projection can be advanced;
- placing the blank in register between the two tool portions in such a way that the outer portion of the at least one extension member is arranged between the corresponding recess and projection and the first surface of the inner portion of the at least one extension member as well as the first surface of the blank in the vicinity of the projection are supported by a surface surrounding the recess;
- advancing the two tool portions toward each other until the second surface of the outer portion (304) of the extension is in contact with the corresponding projection, the second surface of the inner portion of the at least one extension member as well as the second surface of the blank in the vicinity of the projection being free;
- further advancing the two tool portions toward each other, the projection forcing the outer portion of the extension into the recess thereby providing a plastic deformation substantially corresponding to the attachment of the outer portion of the extension to the inner portion of the extension, wherein the free second surface of the inner portion of the at least one extension member as well as the second surface of the blank in the vicinity of the projection remain free during the initial or the entire movement of the projection into the recess;
- taking the two tool portions away from each and removing the processed blank comprising the bend outer portion of the at least one extension.

12. A method as defined in claim 11, wherein the blank comprises a plurality of extensions to be bend and the bending tool comprises a plurality of corresponding projections and recesses.

13. A method as defined in claim 12, wherein each of the two tool portions each comprise both at least one projection and at least one recess, whereby extensions on the blank can be bend in opposite directions.

14. A method as defined in any of claims 11-13, wherein the base member is a substantially planar, thin metal member, preferably with a thickness less than 1 mm, and comprises a rim portion having a plurality of finger-like extensions arranged thereon.

15. A method as defined in claim 14, wherein the blank comprises at least one closed rim-like portion, the bend extensions forming spring contacts.

16. A method as defined in any of claims 11-15, wherein a first portion of the inner portion has a reduced thickness and a second portion of the inner portion comprises a protruding contact means (305), the first portion being arranged between the base member and the second portion, and wherein the contact means, preferably, is formed integrally with the extension and has a thickness substantially corresponding to the portion of the base member to which it is attached.

## Patentansprüche

1. Leitende Kontakteinrichtung zur Herstellung eines Kontakts zwischen zwei Komponenten, umfassend:
ein Basiselement (242), das eine Hauptebene definiert und wenigstens eine Erweiterung (243) aufweist, die von dem Basiselement vorsteht, wobei das Basiselement und die Erweiterung beide eine erste Oberfläche (240) und eine gegenüberliegende zweite Oberfläche (241) haben, wobei die Erweiterung (243) einen inneren Abschnitt (244) und einen äußeren Abschnitt (245) umfasst, wobei der innere Abschnitt (244) mit dem Basiselement verbunden ist, der äußere Abschnitt (245) in Bezug auf den inneren Abschnitt und aus der Hauptebene des Basiselements heraus gebogen ist, wobei ein erster Abschnitt des inneren Abschnitts (244) eine verminderte Dicke aufweist und ein zweiter Abschnitt des inneren Abschnitts eine vorstehende Kontakteinrichtung (249) umfasst, wobei der erste Abschnitt zwischen dem Basiselement und dem zweiten Abschnitt angeordnet ist.

2. Leitende Kontakteinrichtung nach Anspruch 1, wobei die verminderte Dicke durch ein Formätzverfahren erreicht wird.

3. Leitende Kontakteinrichtung nach Anspruch 2, wobei die Kontakteinrichtung einteilig mit der Erweiterung geformt ist und eine Dicke aufweist, die im Wesentlichen dem Abschnitt des Basiselements entspricht, an dem sie angebracht ist.

4. Leitende Kontakteinrichtung nach einem der Ansprüche 1 bis 3, wobei das Basiselement einen fassungsrandartigen Abschnitt mit einer generellen Längskonfiguration, die eine generelle Längsausrichtung definiert, umfasst, und wobei der äußere Abschnitt entlang einer Biegelinie, die in Bezug auf die generelle Längsausrichtung des fassungsrandartigen Abschnitts nicht senkrecht ist, aus der Hauptebene des Basiselements herausgebogen ist.

5. Leitende Kontakteinrichtung nach einem der Ansprüche 1 bis 4, wobei die Erweiterung eine generelle Längskonfiguration aufweist, die eine Längsausrichtung definiert, und wobei der äußere Abschnitt entlang einer Biegelinie, die in Bezug auf die Längsausrichtung der Erweiterung nicht senkrecht ist, aus der Hauptebene des Basiselements herausgebogen ist.

6. Leitende Kontakteinrichtung nach einem der Ansprüche 1 bis 5, wobei der innere Abschnitt entweder in der Hauptebene des Basiselements angeordnet ist oder aus dieser herausgebogen ist.

7. Leitende Kontakteinrichtung nach einem der Ansprüche 2 bis 6, wobei die erste Oberfläche der Erweiterung und die erste Oberfläche des Abschnitts des Basiselements, an dem sie angebracht ist, eine zusammenhängende, stufenlose Oberfläche bilden.

8. Leitende Kontakteinrichtung, wobei das Basiselement einen Fassungsrandabschnitt mit mehreren fingerartigen Erweiterungen, die daran angeordnet sind, umfasst, wobei wenigstens einer davon wie in einem der Ansprüche 1 bis 7 definiert beschaffen ist.

9. Leitende Kontakteinrichtung nach Anspruch 8, wobei das Basiselement ein im Wesentlichen ebenes, dünnes Metallelement ist, vorzugsweise mit einer Dicke, die kleiner als 1 mm ist.

10. Leitende Kontakteinrichtung nach Anspruch 9, wobei das Rohteil wenigstens einen geschlossenen fassungsrandartigen Abschnitt umfasst, wobei die gebogenen Erweiterungen Federkontakte bilden.

11. Verfahren zum Biegen wenigstens einer Erweiterung, die von einem Basiselement vorsteht, wobei das Verfahren die folgenden Schritte umfasst:
- Bereitstellen eines Rohteils, das ein Basiselement (301) mit wenigstens einer Erweiterung (302), die von dem Basiselement in einer Hauptebene des Basiselements vorsteht, umfasst, wobei beide, das Basiselement und die Erweiterung, eine erste Oberfläche und eine gegenüberliegende zweite Oberfläche besitzen, die Erweiterung einen inneren Abschnitt (303) und einen äußeren Abschnitt (304) umfasst, wobei der innere Abschnitt mit dem Basiselement verbunden ist und der äußere Abschnitt eine verminderte Dicke in Bezug auf den Abschnitt des Basiselements hat, an dem die Erweiterung angebracht ist;
- Bereitstellen eines Biegewerkzeugs, das einen ersten und einen zweiten Werkzeugabschnitt (100, 200) umfasst, wobei die Werkzeugabschnitte, wenn sie passgenau zueinander und zu dem Rohteil angeordnet sind, wenigstens einen Vorsprung (201) an einem der Werkzeugabschnitte und in dem anderen Werkzeugabschnitt eine entsprechende Aussparung (101), in welche der Vorsprung vorgeschoben werden kann, umfassen;
- passgenaues Anordnen des Rohteils zwischen den zwei Werkzeugabschnitten, derart, dass der äußere Abschnitt des wenigstens einen Erweiterungselements zwischen der entsprechenden Aussparung und dem entsprechenden Vorsprung angeordnet ist, und sowohl die erste Oberfläche des inneren Abschnitts des wenigstens einen Erweiterungselements als auch die erste Oberfläche des Rohteils in der Nähe des Vorsprungs durch eine die Aussparung umgebende Fläche unterstützt werden;
- Aufeinanderzubewegen der zwei Werkzeugabschnitte, bis die zweite Oberfläche des äußeren Abschnitts (304) der Erweiterung mit dem entsprechenden Vorsprung in Kontakt ist, wobei sowohl die zweite Oberfläche des inneren Abschnitts des wenigstens einen Erweiterungselements als auch die zweite Oberfläche des Rohteils in der Nähe des Vorsprungs frei sind;
- weiteres Aufeinanderzubewegen der zwei Werkzeugabschnitte, wobei der Vorsprung den äußeren Abschnitt der Erweiterung in die Aussparung drängt, wodurch für eine bleibende Verformung gesorgt wird, die im Wesentlichen der Befestigung des äußeren Abschnitts der Erweiterung an dem inneren Abschnitt der Erweiterung entspricht, wobei sowohl die freie zweite Oberfläche des inneren Abschnitts des wenigstens einen Erweiterungselements als auch die zweite Oberfläche des Rohteils in der Nähe des Vorsprungs während der anfänglichen oder der gesamten Bewegung des Vorsprungs in die Aussparung frei bleiben;
- Wegnehmen der zwei Werkzeugabschnitte und Entfernen des bearbeiteten Rohteils, das den gebogenen äußeren Abschnitt der wenigstens einen Erweiterung aufweist.

12. Verfahren nach Anspruch 11, wobei das Rohteil mehrere zu biegende Erweiterungen aufweist und das Biegewerkzeug mehrere entsprechende Vorsprünge und Aussparungen aufweist.

13. Verfahren nach Anspruch 12, wobei jeder der zwei Werkzeugabschnitte sowohl wenigstens einen Vorsprung als auch wenigstens eine Aussparung aufweist, wodurch Erweiterungen an dem Rohteil in entgegengesetzte Richtungen gebogen werden können.

14. Verfahren nach einem der Ansprüche 11 bis 13, wobei das Basiselement ein im Wesentlichen ebenes, dünnes Metallelement ist, vorzugsweise mit einer Dicke von weniger als 1 mm, das einen Fassungsrandabschnitt mit mehreren fingerartigen Erweiterungen, die daran angeordnet sind, umfasst.

15. Verfahren nach Anspruch 14, wobei das Rohteil wenigstens einen geschlossenen fassungsrandartigen Abschnitt umfasst, wobei die gebogenen Erweiterungen Federkontakte bilden.

16. Verfahren nach einem der Ansprüche 11 bis 15, wobei ein erster Abschnitt des inneren Abschnitts eine verminderte Dicke hat und ein zweiter Abschnitt des inneren Abschnitts eine vorstehende Kontakteinrichtung (305) aufweist, wobei der erste Abschnitt zwischen dem Basiselement und dem zweiten Abschnitt angeordnet ist und wobei die Kontakteinrichtung vorzugsweise einteilig mit der Erweiterung ausgebildet ist und eine Dicke aufweist, die im Wesentlichen dem Abschnitt des Basiselements, an dem sie angebracht ist, entspricht.

## Revendications

1. Moyen de contact conducteur en vue de fournir un contact entre deux composants, comprenant un élément de base (242) définissant un plan général et possédant au moins un prolongement (243) faisant saillie depuis l'élément de base, l'élément de base et le prolongement possédant tous deux une première surface (240) et une deuxième surface opposée (241), dans lequel le prolongement (243) comprend une portion interne (244) et une portion externe (245), la portion interne (244) étant connectée à l'élément de base, la portion externe (245) étant courbée par rapport à la portion interne et en dehors du plan général de l'élément de base, dans lequel une première portion de la portion interne (244) possède une épaisseur réduite et une deuxième portion de la portion interne comprend un moyen de contact faisant saillie (249), la première portion étant agencée entre l'élément de base et la deuxième portion.

2. Moyen de contact conducteur selon la revendication 1, dans lequel l'épaisseur réduite est réalisée au moyen d'un processus de fraisage chimique.

3. Moyen de contact conducteur selon la revendication 2, dans lequel le moyen de contact est formé de manière intégrale avec le prolongement et possède une épaisseur correspondant essentiellement à la portion de l'élément de base à laquelle il est relié.

4. Moyen de contact conducteur selon l'une quelconque des revendications 1 à 3, dans lequel l'élément de base comprend une portion de type rebord possédant une configuration longitudinale générale définissant une orientation longitudinale générale et dans lequel la portion externe est courbée en dehors du plan général de l'élément de base le long d'une ligne de courbure qui n'est pas perpendiculaire par rapport à l'orientation longitudinale générale de la portion de type rebord.

5. Moyen de contact conducteur selon l'une quelconque des revendications 1 à 4, dans lequel le prolongement possède une configuration longitudinale générale définissant une orientation longitudinale et dans lequel la portion externe est courbée en dehors du plan général de l'élément de base le long d'une ligne de courbure qui n'est pas perpendiculaire par rapport à l'orientation longitudinale du prolongement.

6. Moyen de contact conducteur selon l'une quelconque des revendications 1 à 5, dans lequel la portion interne est agencée soit à l'intérieur soit courbée en dehors du plan général de l'élément de base.

7. Moyen de contact conducteur selon l'une quelconque des revendications 2 à 6, dans lequel la première surface du prolongement et la première surface de la portion de l'élément de base à laquelle il est relié forment une surface continue non étagée.

8. Moyen de contact conducteur, dans lequel l'élément de base comprend une portion de rebord possédant une pluralité de prolongements de type doigts agencés sur celle-ci, au moins l'un de ceux-ci selon l'une quelconque des revendications 1 à 7.

9. Moyen de contact conducteur selon la revendication 8, dans lequel l'élément de base est un élément métallique fin essentiellement plan, de préférence possédant une épaisseur inférieure à 1 mm.

10. Moyen de contact conducteur selon la revendication 9, dans lequel le flan comprend au moins une portion de type rebord fermée, les prolongements courbés formant des contacts de ressort.

11. Procédé en vue de courber au moins un prolongement faisant saillie depuis un élément de base, le procédé comprenant les étapes consistant à :
- fournir un flan comprenant un élément de base (301) possédant au moins un prolongement (302) faisant saillie depuis l'élément de base dans un plan général de l'élément de base, l'élément de base et le prolongement possédant tous deux une première surface et une deuxième surface opposée, le prolongement comprenant une portion interne (303) et une portion externe (304), la portion interne étant connectée à l'élément de base, et la portion externe possédant une épaisseur réduite par rapport à la portion de l'élément de base à laquelle le prolongement est relié ;
- fournir un outil de courbure comprenant une première et une deuxième portion d'outil (100, 200), les portions d'outil comprenant, lorsqu'elles sont agencées point sur point l'une avec l'autre et avec le flan, au moins une saillie (201) sur l'une des portions d'un retrait correspondant (101) dans l'autre portion d'outil dans laquelle la saillie peut être avancée ;
- placer le flan point sur point entre les deux portions d'outil de manière à ce que la portion externe de l'au moins un élément de prolongement soit agencée entre le retrait correspondant et la saillie et la première surface de la portion interne de l'au moins un élément de prolongement ainsi que la première surface du flan à proximité de la saillie sont supportées par une surface entourant le retrait ;
- faire avancer les deux portions d'outil l'une vers l'autre jusqu'à ce que la deuxième surface de la portion externe (304) du prolongement soit en contact avec la saillie correspondante, la deuxième surface de la portion interne de l'au moins un élément de prolongement ainsi que la deuxième surface du flan à proximité de la saillie étant libres ;
- faire avancer davantage les deux portions d'outil l'une vers l'autre, la saillie forçant la portion externe du prolongement dans le retrait, fournissant ainsi une déformation plastique correspondant essentiellement à la liaison de la portion externe du prolongement à la portion interne du prolongement, dans lequel la deuxième surface libre de la portion interne de l'au moins un élément de prolongement ainsi que la deuxième surface du flan à proximité de la saillie restent libres pendant le mouvement initial ou entier de la saillie dans le retrait ;
- éloigner les deux portions d'outil l'une de l'autre et enlever le flan transformé comprenant la portion externe courbée de l'au moins un prolongement.

12. Procédé selon la revendication 11, dans lequel le flan comprend une pluralité de prolongements à courber et l'outil de courbure comprend une pluralité de saillies et retraits correspondants.

13. Procédé selon la revendication 12, dans lequel chacune des deux portions d'outil comprend chacune au moins une saillie et au moins un retrait, ce par quoi les prolongements sur le flan peuvent être courbés dans des directions opposées.

14. Procédé selon l'une quelconque des revendications 11 à 13, dans lequel l'élément de base est un élément métallique fin essentiellement plan, de préférence possédant une épaisseur inférieure à 1 mm, et comprend une portion de rebord possédant une pluralité de prolongements de type doigts agencés sur celle-ci.

15. Procédé selon la revendication 14, dans lequel le flan comprend au moins une portion de type rebord fermée, les prolongements courbés formant des contacts de ressort.

16. Procédé selon l'une quelconque des revendications 11 à 15, dans lequel une première portion de la portion interne possède une épaisseur réduite et une deuxième portion de la portion interne comprend un moyen de contact faisant saillie (305), la première portion étant agencée entre l'élément de base et la deuxième portion, et dans lequel le moyen de contact, de préférence, est formé de manière intégrale avec le prolongement et possède une épaisseur correspondant essentiellement à la portion de l'élément de base à laquelle il est relié.
